# EUROPEAN PATENT APPLICATION

(11) **EP 4 574 549 A1**
(43) Date of publication of application: **25.06.2025**
(21) Application number: 24220448.5
(22) Date of filing: 17.12.2024
(51) Int. Cl.: B60L 53/65, B60L 53/80, B60S 5/06, H01M 10/42

(54) **INFORMATION PROCESSING APPARATUS, EVALUATION METHOD, AND EVALUATION PROGRAM**

(30) Priority: 22.12.2023 JP 2023217172
(71) Applicant: Yokogawa Electric Corporation, Tokyo 180-8750 (JP)
(72) Inventor: TERAO, Minako, Musashino-shi, Tokyo, 180-8750, (JP); TAKENAKA, Kazuma, Musashino-shi, Tokyo, 180-8750, (JP); TSUKANO, Masahito, Musashino-shi, Tokyo, 180-8750, (JP); TORAI, Soichiro, Musashino-shi, Tokyo, 180-8750, (JP); NOGUCHI, Naoki, Musashino-shi, Tokyo, 180-8750, (JP); YOSHITAKE, Satoshi, Musashino-shi, Tokyo, 180-8750, (JP)
(74) Representative: Winter, Brandl - Partnerschaft mbB

(57) **Abstract**

An information processing apparatus 10 includes an acquisition unit 15B that acquires a magnetic field distribution of a battery that is installed in a vehicle, a determination unit 15C that performs authenticity determination on whether the battery is a genuine product based on the magnetic field distribution of the battery, an evaluation unit 15D that evaluates a charging device serving as a delivery source of the battery that is installed in the vehicle among charging devices that charge a battery that is brought by a user and deliver a charged battery to the user in place of the battery, based on a result of the authenticity determination, and an output unit 15E that outputs evaluation of the charging device, where the evaluation is made by the evaluation unit 15D.

## Description

### BACKGROUND OF THE INVENTION

### 1. Field of the Invention

The present invention relates to an information processing apparatus, an evaluation method, and a non-transitory computer readable recording medium.

### 2. Description of the Related Art

From the viewpoint of realizing carbon neutral, an electric car, what is called an Electric Vehicle (xEV), that is driven by a motor that uses electricity as a power source is becoming popular. With the spread of xEV as described above, an active approach is taken to a battery sharing service that shares a battery by adopting a battery replacement system for xEV by providing a charging device that replaces a low-charge battery with a charged battery.

For example, a charging device search function has been provided to search for a charging device that is arranged in a place that is designated by a user who uses the battery sharing service from among charging devices, such as stations, that are operated by business operators who provide the battery sharing service as described above.
Patent document 1: Japanese Unexamined Patent Application Publication No. 2020-169932
Patent document 2: Japanese Unexamined Patent Application Publication No. 2012-75212
Patent document 3: Japanese Unexamined Patent Application Publication No. 2012-49030

However, in the charging device search function as described above, in some aspects, it is difficult to provide information that contributes to determination on whether or not the charging device is good.

An object of the present invention is to provide information that contributes to determination on whether or not a charging device is good.

### SUMMARY OF THE INVENTION

According to one aspect of embodiments, an information processing apparatus includes: an acquisition unit configured to acquire a magnetic field distribution of a battery that is installed in a vehicle; a determination unit configured to perform authenticity determination on whether the battery is a genuine product based on the magnetic field distribution of the battery; an evaluation unit configured to evaluate a charging device serving as a delivery source of the battery that is installed in the vehicle among charging devices that charge a battery that is brought by a user and deliver a charged battery to the user in place of the battery, based on a result of the authenticity determination; and an output unit configured to output evaluation of the charging device, the evaluation being made by the evaluation unit.

According to one aspect of embodiments, an evaluation method carried out by a computer includes: acquiring a magnetic field distribution of a battery that is installed in a vehicle; performing authenticity determination on whether the battery is a genuine product based on the magnetic field distribution of the battery; evaluating a charging device serving as a delivery source of the battery that is installed in the vehicle among charging devices that charge a battery that is brought by a user and deliver a charged battery to the user in place of the battery, based on a result of the authenticity determination; and outputting evaluation of the charging device.

According to one aspect of embodiments, an evaluation program causes a computer to execute a process including: acquiring a magnetic field distribution of a battery that is installed in a vehicle; performing authenticity determination on whether the battery is a genuine product based on the magnetic field distribution of the battery; evaluating a charging device serving as a delivery source of the battery that is installed in the vehicle among charging devices that charge a battery that is brought by a user and deliver a charged battery to the user in place of the battery, based on a result of the authenticity determination; and outputting evaluation of the charging device.

### ADVANTAGEOUS EFFECTS OF INVENTION

According to one embodiment, it is possible to provide information that contributes to determination on whether or not a charging device is good.

### BRIEF DESCRIPTION OF THE DRAWINGS

FIG. 1 is a diagram illustrating a configuration example of a battery sharing system;
FIG. 2 is a schematic diagram illustrating an example of battery replacement;
FIG. 3 is a schematic diagram illustrating an example of measurement of a magnetic field distribution of a battery;
FIG. 4 is a diagram illustrating one aspect of a problem-solving approach;
FIG. 5 is a block diagram illustrating a functional configuration example of a server device;
FIG. 6 is a schematic diagram illustrating an example of update of evaluation information;
FIG. 7 is a schematic diagram illustrating an example of update of the evaluation information;
FIG. 8 is a diagram illustrating a display example of an on-vehicle device;
FIG. 9 is a diagram illustrating a display example of the on-vehicle device;
FIG. 10 is a diagram illustrating a display example of the on-vehicle device;
FIG. 11 is a diagram illustrating a display example of the on-vehicle device;
FIG. 12 is a flowchart illustrating the flow of a station evaluation process;
FIG. 13 is a diagram illustrating an application example of the on-vehicle device;
FIG. 14 is a diagram illustrating a hardware configuration example.

### DETAILED DESCRIPTION OF THE PREFERRED EMBODIMENTS

Modes (hereinafter, described as "embodiments") for carrying out an information processing apparatus, an evaluation method, and an evaluation program according to the present application will be described below with reference to the accompanying drawings. Each of the embodiments illustrate only examples and aspects, and examples do not limit numerical values, functional ranges, usage scenes, or the like. In addition, the embodiments may be combined adaptively as long as processing contents do not conflict with each other.

### Overall configuration

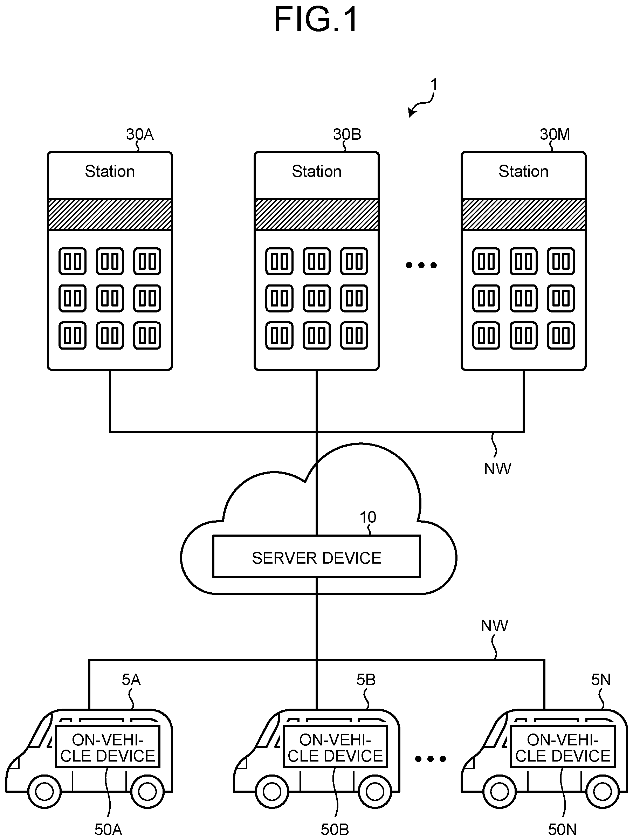

FIG. 1 is a diagram illustrating a configuration example of a battery sharing system. A battery sharing system 1 illustrated in FIG. 1 provides a battery sharing service that achieves sharing of a battery by adopting a battery replaceable system for vehicles 5A to 5N, such as xEV. Meanwhile, as an example of a usage scene of the battery, xEV is described as one example, but the battery need not always be installed in the vehicle, but may be installed in a general load device, such as a construction machine, an agricultural machine, or a home appliance.

The "battery" described herein may indicate a secondary battery, a lithium ion battery, or an assembled battery. For example, the "battery" may be a "cell" that indicates a single battery, a "module" that indicates an assembled battery in which a plurality of cells are assembled, or a "pack" that indicates an assembled battery in which a plurality of modules are assembled.

As illustrated in FIG. 1, the battery sharing system 1 may include a server device 10, stations 30A to 30M, on-vehicle devices 50A to 50N that are mounted on the vehicles 5A to 5N. In the following, when the stations 30A to 30M need not be distinguished from one another, the stations 30A to 30M may be described as a "station 30". Further, when the vehicles 5A to 5N need not be distinguished from one another, the vehicles 5A to 5N may be described as a "vehicle 5". Furthermore, when the on-vehicle devices 50A to 50N need not be distinguished from one another, the on-vehicle devices 50A to 50N may be described as an "on-vehicle device 50".

The server device 10, the station 30, and the on-vehicle device 50 may be communicably connected to one another via an arbitrary network NW. Meanwhile, the network NW may be implemented by an arbitrary technology, such as an Internet technology, an industrial communication standard, or a low power radio communication standard for Internet of Things (IoT), regardless of whether the network is wired or wireless.

The server device 10 is one example of an information processing apparatus that provides the battery sharing service as described above. For example, the server device 10 is able to provide the battery sharing service as described above as a cloud service by being implemented as an application of a Platform as a Service (PaaS) type or a Software as a Service (SaaS) type. In addition, the server device 10 may be implemented as a server that provides a battery sharing function for realizing the battery sharing service as described above on-premises.

In the battery sharing service as described above, a station evaluation function that evaluates the station 30 that corresponds to one example of the charging device as described above may be packaged as a part of information provision to a user who uses the battery sharing service.

The station 30 corresponds to one example of the charging device that replaces a low-charge battery and a charged battery. The station 30 includes a plurality of slots to and from which batteries are attachable and detachable. The station 30 as described above is able to charge a battery that is attached to an empty slot among the plurality of slots and allows extraction of a charged battery from a charged slot.

The on-vehicle device 50 is a terminal device that is mounted on the vehicle 5, such as an electric car, what is called xEV, that is driven by a motor that uses electricity as a power source. The on-vehicle device 50 as described above corresponds to one example of a client terminal that receives the station evaluation function as described above, and may be used by a user who uses the battery sharing service as described above, for example.

### Battery replacement

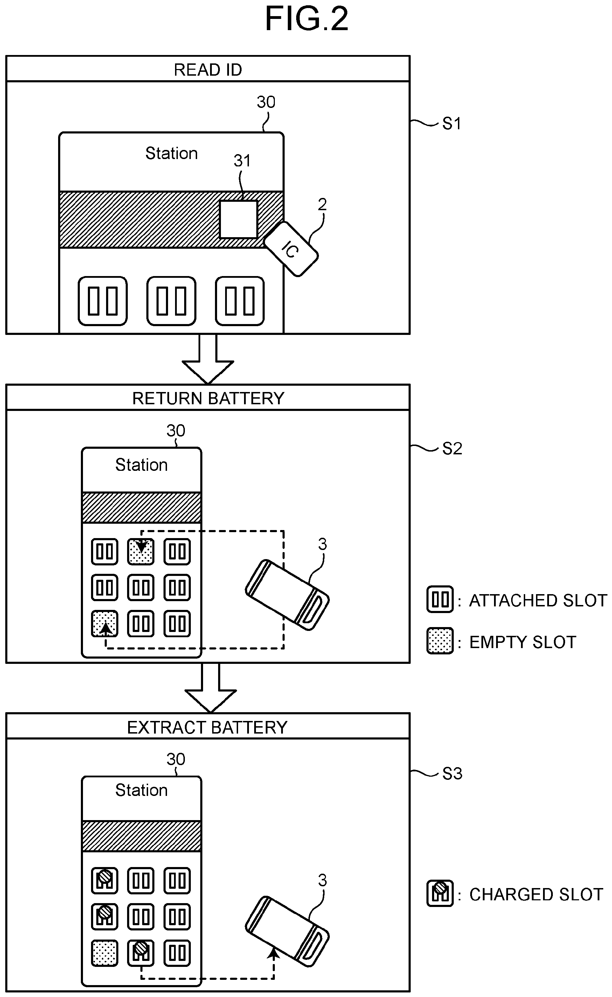

FIG. 2 is a schematic diagram illustrating one example of battery replacement. As illustrated in FIG. 2, the station 30 reads identification information, such as a user IDentification (ID), on a user who uses the battery sharing service as described above (Step S1).

For example, the user performs operation of bringing an Integrated Circuit (IC) card 2, which is owned by the user, to an information reading unit 31 of the station 30, and the information reading unit 31 reads the user ID that is recorded in the IC card 2.

With the user ID that is read by the information reading unit 31 as described above, user authentication for determining whether the user is a legitimate user who is registered in advance and payment of charge for paying a fee for using the battery sharing service as described above are performed.

Thereafter, by attaching a battery 3 that is removed from the vehicle 5, such as EV, to an empty slot to which a battery is not attached among the plurality of slots included in the station 30, the battery 3 is returned (Step S2).

At the time of return of the battery 3 as described above, a display unit, such as a lamp, that is associated with each of the slots, is able to perform display in different display modes between an empty slot and other slots.

After the battery 3 is returned, the battery 3 is extracted from a charged slot among the plurality of slots included in the station 30 (Step S3). Meanwhile, the "charged" is one example, and may indicate a fully charged state, but need not always indicate the fully charged state. For example, a slot to which a battery with a State Of Charge (SOC) being equal to or larger than a lower limit, such as 95%, is attached may be identified as the charged slot.

The battery 3 that is extracted from the charged slot as described above is installed in the vehicle 5 or the like of the user. Through the operation from Step S1 to Step S3, it is possible to replace the battery 3.

Meanwhile, FIG. 2 illustrates, as one example, an example in which the user who is already registered performs battery replacement; however, it is of course possible for a new user to replace a battery.

### Magnetic field distribution

While xEV is becoming popular, as a battery of xEV, a non-genuine product that is not a genuine product is circulating in addition to the genuine product that is manufactured by a manufacturer. For example, as a non-genuine product, an imitation product in which not only an appearance of housing of a normal module or a normal package, but also two-dimensional code that is linked to management information, such as a battery passport for managing a life cycle from material procurement to recycle of a battery, is imitated is present.

From this point of view, the server device 10 according to the present embodiment performs authenticity determination on whether or not the battery that is installed in the vehicle 5 after replacement of the battery is a genuine product. For example, the authenticity determination as described above is performed by adopting a battery characteristic of a genuine battery as a reference, and comparing the reference battery characteristic and a battery characteristic that is measured from an identification target battery.

In the following, an example in which the authenticity determination as described above is performed by using a magnetic field distribution of a battery as one example of the battery characteristic of the battery will be described below. As only one example, when the battery 3 that is extracted at Step S3 illustrated in FIG. 2 is installed in the vehicle 5, the on-vehicle device 50 is able to acquire a magnetic field distribution of the battery 3.

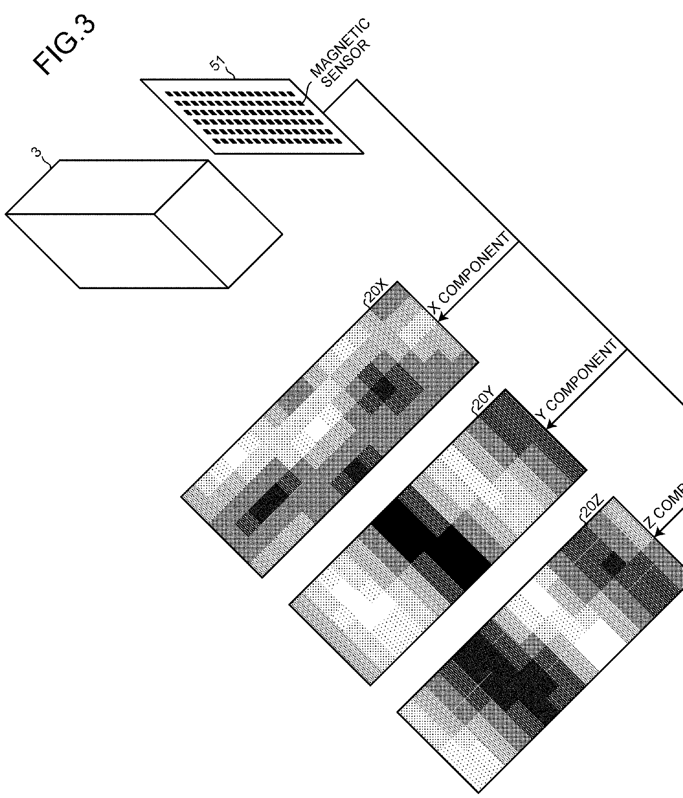

FIG. 3 is a schematic diagram illustrating an example of measurement of the magnetic field distribution of the battery. As illustrated in FIG. 3, the magnetic field distribution of the battery 3 is measured by a measurement unit 51 that is implemented by magnetic sensors that are arranged in a two-dimensional array. For example, in the example illustrated in FIG. 3, the measurement unit 51 is implemented by arranging, on a side surface of the battery 3 that is installed in the vehicle 5, magnetic sensors in an array of 6 columns and 16 rows.

A map of measurement values, such as magnetic flux densities, that are measured by the magnetic sensors in the array of 6 columns and 16 rows is obtained as a magnetic field distribution 20 of the battery 3. For example, when the measurement unit 51 is implemented by a three-axis magnetic sensor, a magnetic field distribution 20X of an X component, a magnetic field distribution 20Y of a Y component, and a magnetic field distribution 20Z of a Z component are obtained as the magnetic field distribution 20 of the battery 3.

Meanwhile, FIG. 3 illustrates only one example; therefore, the measurement unit 51 may be implemented by a single-axis magnetic sensor or a two-axis magnetic sensor, and an array of the magnetic sensors may be implemented by an arbitrary array including a one-dimensional array. For example, the magnetic sensors may be analog elements or digital elements. Each of magnetic elements is, for example, a Hall element, a magneto impedance element with magneto resistive element Magneto-Impedance (MI), such as an AMR (Anisotropic magneto resistance effect), a GMR (Giant magneto resistance effect), or a TMR (Tunnel magneto resistance effect), or a thin film magnetic element with an abnormal hall effect using a flux gate or a topological magnetic material. When an alternating current flows through a measurement target, it may be possible to use a pickup coil as the magnetic element.

### One aspect of problem

As explained in the section of the background technology as described above, in the charging device search function as described above, in some aspects, it may be difficult to provide information that contributes to determination on whether or not the charging device is good.

### One aspect of problem-solving approach

Therefore, the server device 10 according to the present embodiment provides a station evaluation function for evaluating the station 30 that serves as a delivery source of a battery, based on a result of authenticity determination on a battery that is installed in the vehicle 5.

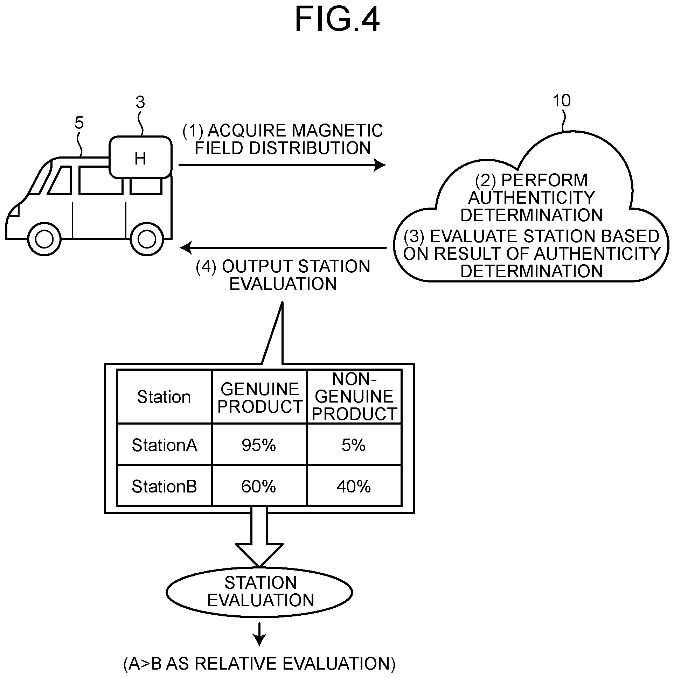

FIG. 4 is a diagram illustrating one aspect of a problem-solving approach. As illustrated in FIG. 4, the server device 10 acquires a magnetic field distribution of the battery 3 that is installed in the vehicle 5 (1). Further, the server device 10 performs authenticity determination on whether or not the battery 3 is a genuine product based on the magnetic field distribution of the battery 3 (2). Thereafter, the server device 10 evaluates the station 30 serving as a delivery source of the battery 3 based on a result of the authenticity determination on the battery 3 (3).

Here, as an example of the station evaluation as described above, it is possible to calculate various kinds of evaluation values based on the result of the authenticity determination. As one example of the evaluation value as described above, it is possible to calculate, as a genuine product delivery probability, a probability that the battery that is delivered from the station 30 to a user is determined as a genuine product. As another example, it is possible to calculate, as a non-genuine product delivery probability, a probability that the battery that is delivered from the station 30 to the user is determined as a non-genuine product. One of the factors that a non-genuine product is attached to the slot of the station 30 is that a genuine battery has higher values than a non-genuine battery in terms of performance aspects and financial aspects. This may cause a dishonest business operator who commits fraud by collecting a genuine product from a user and delivering a non-genuine product to the user at the station 30 among business operators who provide the battery sharing service as described above. As one example of an evaluation value that indicates a degree that the business operator is not a dishonest business operator, it is possible to calculate the genuine product delivery probability as described above. Further, as one example of an evaluation value that indicates a degree that the business operator is a dishonest business operator, it is possible to calculate the non-genuine product delivery probability as described above.

Furthermore, the server device 10 outputs the station evaluation that is obtained at (3) to the on-vehicle device 50 (4). For example, in the example of (4) illustrated in FIG. 4, station evaluation that includes a genuine product delivery probability and a non-genuine product delivery probability of a station A and a genuine product delivery probability and a non-genuine product delivery probability of a station B. Accordingly, it is possible to relatively evaluate the station A and the station B. In other words, from the station evaluation indicating that the genuine product delivery probability of the station A > the genuine product delivery probability of the station B or the non-genuine product delivery probability of the station A < the non-genuine product delivery probability of the station B, it is possible to determine that the station A is a more excellent store than the station B.

As only one example, a case will be described below in which a station that is best located for a user, such as a station that is located closest to home or a garage of the user, between the station A and the station B is the station B. In this case, according to the search function of the charging device that is explained in the section of the background technology as described above, the station B is obtained as a search result of the station 30 that is best located for the user. However, even when the station B is best located for the user, the station B is not always an excellent store. This is because, as is clear from the station evaluation, such as the genuine product delivery probability and the non-genuine product delivery probability, as illustrated in (4) in FIG. 4, the station A is more likely not to be a dishonest business operator or is less likely to be a dishonest business operator than the station B. In this manner, according to the station evaluation illustrated in (4) in FIG. 4, it is possible to realize the station evaluation that is not provided by the search function of the charging device as described above.

In view of the above, according to the station evaluation function of the present embodiment, it is possible to provide information that contributes to determination on whether or not the charging device is good. Furthermore, it is possible to perform calculation related to the station evaluation without using a complicated algorithm, so that it is possible to reduce a calculation cost related to the station evaluation.

Meanwhile, in the following, as only one example, an example will be described in which the station evaluation function as described above is packaged as one function of the battery sharing service as described above; however, the station evaluation function as described above may be provided as a service that is separated from the battery sharing service as described above.

### Configuration of server device 10

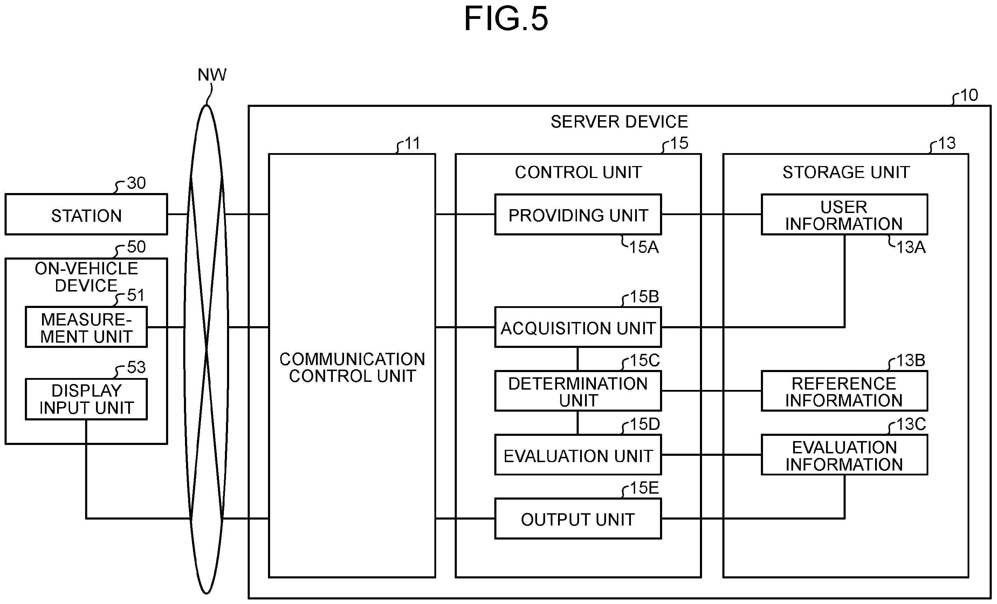

A functional configuration example of the server device 10 according to the present embodiment will be described below. FIG. 5 is a block diagram illustrating a functional configuration example of the server device 10. FIG. 5 schematically illustrates blocks that are included in the server device 10 and that are related to the battery sharing service.

As illustrated in FIG. 5, the server device 10 includes a communication control unit 11, a storage unit 13, and a control unit 15. Meanwhile, FIG. 5 illustrates only functional units that are related to the battery sharing service as described above, and the server device 10 may include functional units other than those illustrated in the drawings.

The communication control unit 11 is a functional unit that controls communication with a different device, such as the station 30 or the on-vehicle device 50. As only one example, the communication control unit 11 may be implemented by a network interface card. As one aspect, the communication control unit 11 is able to receive the user ID or the magnetic field distribution of the battery 3 from the station 30, or output permission or refusal of replacement of a battery. As another aspect, the communication control unit 11 is able to receive the user ID or the magnetic field distribution of the battery 3 from the on-vehicle device 50, or output station evaluation to the on-vehicle device 50.

The storage unit 13 is a functional unit that stores therein various kinds of data. As only one example, the storage unit 13 is implemented by an internal storage, an external storage, or an auxiliary storage of the server device 10. For example, the storage unit 13 stores therein user information 13A, reference information 13B, and evaluation information 13C. Meanwhile, the user information 13A, the reference information 13B, and the evaluation information 13C will be described in the following description of a case in which reference, generation, or registration is performed.

The control unit 15 is a functional unit that controls the entire server device 10. For example, the control unit 15 may be implemented by a hardware processor. As illustrated in FIG. 5, the control unit 15 includes a providing unit 15A, an acquisition unit 15B, a determination unit 15C, an evaluation unit 15D, and an output unit 15E. Meanwhile, the control unit 15 may be implemented by a hard wired logic or the like.

The providing unit 15A is a processing unit that provides the battery sharing service as described above. As one aspect, upon receiving the user ID from the station 30, the providing unit 15A performs user authentication by referring to the user information 13A that is stored in the storage unit 13. Here, the user information 13A may be a set of pieces of data that are associated with various kinds of information including payment information on a credit card, electronic money, or the like for each of user IDs. For example, the user authentication as described above may be implemented by comparing the user ID that is recorded in the user information 13A and the user ID that is received from the station 30, and determining whether or not the user is a legitimate user for whom the user ID is registered in the user information 13A.

When the user authentication as described above is successful, the providing unit 15A outputs, to the station 30, an instruction to attach the battery to an empty slot. Further, when the battery that is brought to the station 30 by the user is attached to the empty slot of the station 30, the providing unit 15A is able to acquire a battery ID of the battery that is attached to the empty slot of the station 30. In the following, the battery that is brought to the station 30 by the user may be described as a "brought battery". For example, it may be possible to acquire the battery ID that is recorded in an IC chip that is mounted on the battery. It may be possible to record, in the user information 13A, a history of battery IDs of batteries that are attached to the empty slot of the station 30 as described above. For example, in the user information 13A, time-series data of battery IDs of batteries that are attached to the empty slot of the station 30 by users, may be stored, as a history, for each of user IDs. After the battery ID of the battery that is attached to the empty slot is registered, the providing unit 15A notifies the station 30 of permission for replacement of a battery. The station 30 that is notified of the permission for replacement permits extraction of a battery from a charged slot. Thereafter, when the battery is extracted from the charged slot, the providing unit 15A is able to register, in the user information 13A, a history of the battery ID of the battery that is extracted from the charged slot by the user. For example, it may be possible to store, in the user information 13A, time series data of battery IDs of batteries that are extracted from the charged slot of the station 30 by users, as a history, for each of the user IDs. Meanwhile, the history of the battery IDs may further include times at which batteries are extracted from the charged slot or attached to the empty slot, or identification information (station ID) of the station.

As another aspect, the providing unit 15A is able to pay a fee for battery replacement, in addition to the user authentication as described above. For example, in the case of a user who subscribes a service based on pay-as-you-go pricing that charges for each use of the service, the providing unit 15A is able to pay a charging fee based on the pay-as-you-go pricing by using payment information corresponding to the user ID every time the user ID is acquired from the station 30. Furthermore, in the case of a user who subscribes a recurring billing system, such as a regular billing system or a metered billing system, in which charge is incurred after subscription of a service and payment is continued until withdrawal of the service, the providing unit 15A is able to perform a process as described below. For example, in the case of the regular billing system, the providing unit 15A checks whether or not payment of fees up to a billing date that corresponds to a time point at which the user ID is acquired from the station 30 is completed. Furthermore, in the case of the metered billing system, the providing unit 15A checks whether or not payment of fees that corresponds to a cumulative charge amount at a time point at which the user ID is acquired from the station 30 is completed. As a result, when the payment of fees is completed, the providing unit 15A determines that payment is possible. Moreover, even when the payment of fees is not completed, the providing unit 15A may attempt the payment of fees and if the payment of fees is successful, the providing unit 15A determines that payment is possible.

The acquisition unit 15B is a processing unit that acquires various kinds of information. As one embodiment, when a battery is installed in the vehicle 5, the acquisition unit 15B is able to acquire a user ID, a battery ID, a magnetic field distribution, and a station ID by upload from the on-vehicle device 50 of the vehicle 5.

More specifically, the user ID of a user who receives the station evaluation function as described above is uploaded from the on-vehicle device 50 to the server device 10. Furthermore, the battery ID of the battery that is installed in the vehicle 5 is uploaded from the on-vehicle device 50 to the server device 10. The battery ID that is uploaded at this time may be a battery ID that is recorded in an IC chip that is mounted on the battery. Moreover, it may be possible to assume and acquire, as the battery ID of the battery that is installed in the vehicle 5, a battery ID that is most recently extracted from the charged slot by a user who corresponds to the user ID that is uploaded from the on-vehicle device 50, in the history of battery IDs included in the user information 13A. Furthermore, a magnetic field distribution of the battery that is measured by the measurement unit 51 at the time of installation of the battery in the vehicle 5 is uploaded from the on-vehicle device 50 to the server device 10. Moreover, a station ID of a station at which the battery is charged before the battery is installed in the vehicle 5 is uploaded from the on-vehicle device 50 to the server device 10. The station ID uploaded at this time may be a station ID of a station that is designated as a charging source of the battery via a display input unit 53 that is implemented by a user interface, such as a touch panel, that is mounted on the vehicle 5. Furthermore, it may be possible to assume and acquire, as the station ID of the charging source of the battery, a station ID of a station at which the battery is most recently extracted from the charged slot by a user who corresponds to the user ID that is uploaded from the on-vehicle device 50, in the history of battery IDs included in the user information 13A.

The determination unit 15C is a processing unit that performs authenticity determination on whether or not the battery is a genuine product. As one embodiment, the determination unit 15C performs the authenticity determination as described above by comparing the magnetic field distribution of the battery that is acquired by the acquisition unit 15B and a magnetic field distribution of a genuine battery that is registered as a reference in the reference information 13B that is stored in the storage unit 13.

Here, the reference information 13B may be a set of pieces of data that are associated with magnetic field distributions of genuine batteries as references for each of battery IDs that identify the genuine batteries For example, when the measurement unit 51 of the on-vehicle device 50 is implemented by a three-axis magnetic sensor, the reference information 13B may be stored in association with three magnetic field distributions, such as a magnetic field distribution of an X component, a magnetic field distribution of a Y component, and a magnetic field distribution of a Z component, for each battery ID.

The evaluation unit 15D is a processing unit that evaluates a station that charges a battery before the battery is installed in the vehicle 5, based on a result of the authenticity determination that is performed on the battery by the determination unit 15C. As one embodiment, the evaluation unit 15D is able to calculate various kinds of evaluation values based on the result of the authentication determination that is performed by the determination unit 15C. As one example of the evaluation value as described above, the evaluation unit 15D is able to calculate a frequency at which the battery that is delivered from the station 30 to the user is determined as a genuine product. As another example, the evaluation unit 15D is able to calculate a frequency at which the battery that is delivered from the station 30 to the user is determined as a non-genuine product. The frequencies may include the number of times, probabilities, probability distributions, or the like. In the following, the number of times or the probability that the battery that is delivered from the station 30 to the user is determined as a genuine product may be described as the "number of times of delivery of genuine product" or a "genuine product delivery probability". Further, the number of times or the probability that the battery that is delivered from the station 30 to the user is determined as a non-genuine product may be described as the "number of times of delivery of non-genuine product" or a "non-genuine product delivery probability". As another example, the evaluation unit 15D is able to calculate a statistical value of the evaluation value, such as the genuine product delivery probability or the non-genuine product delivery probability, of the station 30 for each regional classification. The evaluation value of the station 30 that is calculated as described above and the statistical value of the evaluation values of all of stations that belong to a certain ward that is classified by the regional classification are newly registered or updated by overwriting, with respect to the evaluation information 13C that is stored in the storage unit 13.

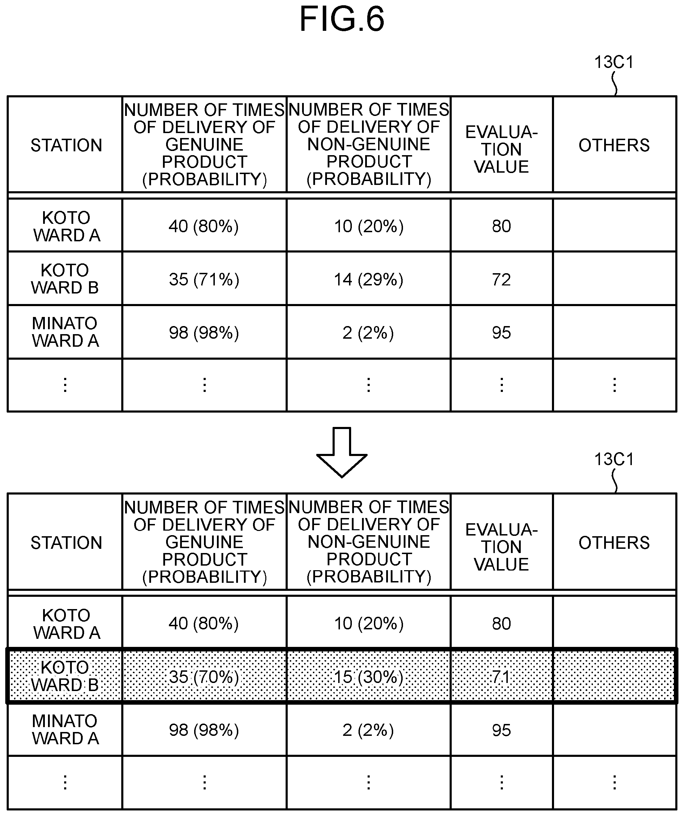

FIG. 6 is a schematic diagram illustrating an example of update of the evaluation information 13C. FIG. 6 illustrates, as an example of the evaluation information 13C, a station evaluation table 13C1 that stores therein evaluation values of the stations 30. As illustrated in FIG. 6, the station evaluation table 13C1 is a table in which items, such as a station, the number of times of delivery of genuine product (probability), the number of times of delivery of non-genuine product (probability), an evaluation value, and others, are associated with one another.

Among the items as described above, the "number of times of delivery of genuine product (probability)" indicates the number of times (probability) that the battery that is delivered from the station 30 to a user is determined as a genuine product. Further, the "number of times of delivery of non-genuine product (probability)" indicates the number of times (probability) that the battery that is delivered from the station 30 to a user is determined as a non-genuine product. Furthermore, the "evaluation value" indicates an evaluation value, such as the number of times of delivery of genuine product (probability), which is evaluated in a specific period of time, such evening or night. Moreover, "other statistical value" indicates recording of a time at which a non-genuine product is delivered, and is used to output, in a graph or the like, information indicating that the non-genuine product delivery probability varies depending on the period of time, for example.

FIG. 6 illustrates an example of update of the station evaluation table 13C1 when an authenticity determination result with respect to a battery that is delivered from a station of "Koto Ward B" to a user is a "non-genuine product". Specifically, the station evaluation table 13C1 before update is illustrated in an upper part of FIG. 6, and the updated station evaluation table 13C1 is illustrated in a lower part of FIG. 6.

In this case, as for the number of times of delivery of non-genuine product at the station of "Koto Ward B", because a result of current authenticity determination indicates a "non-genuine product", the number of times of delivery of non-genuine product at the station "Koto Ward B", that is, "14", is incremented by one. In contrast, the number of times of delivery of genuine product of the station "Koto Ward B" does not change and is not updated.

In this manner, when the "non-genuine product" is obtained as a result of the authenticity determination with respect to the station of "Koto Ward B", the latest number of times of delivery of genuine product remains "35" without being updated, and the latest number of times of delivery of non-genuine product is updated from "14" to "15". Meanwhile, although not illustrated in the drawing, the total number of times of delivery is incremented by one from "49 (= 35 + 14)" to "50".

In this case, the genuine product delivery probability of the station of "Koto Ward B" is updated from "71%" to "70%" by calculation of dividing the latest number of times of delivery of genuine product of "35" by the latest total number of times of delivery of "50". In contrast, the non-genuine product delivery probability of the station of "Koto Ward B" is updated from "29%" to "30%" by calculation of dividing the latest number of times of delivery of non-genuine product of "15" by the latest total number of times of delivery of "50".

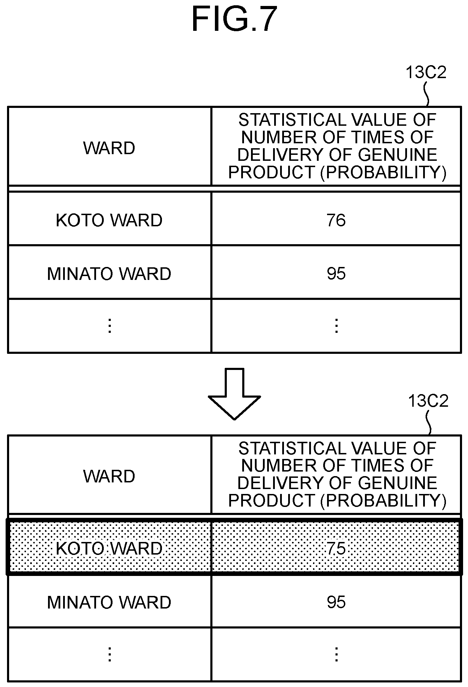

FIG. 7 is a schematic diagram illustrating an example of update of the evaluation information 13C. FIG. 7 illustrates, as an example of the evaluation information 13C, a ward evaluation table 13C2 that stores therein a statistical value of evaluation values of all of stations that belong to a certain ward, for each of wards that are classified by regional classification. As illustrated in FIG. 7, the ward evaluation table 13C2 is a table in which items, such as a ward and an average value of the genuine product delivery probability, are associated with each other.

FIG. 7 illustrates an example of update of the ward evaluation table 13C2 when a "non-genuine product" is obtained as a result of the authenticity determination on a battery that is delivered from the station of "Koto Ward B" that belongs to a ward of "Koto Ward" to the user. Specifically, the ward evaluation table 13C2 before update is illustrated in an upper part of FIG. 7, and the updated ward evaluation table 13C2 is illustrated in a lower part of FIG. 7.

In this case, an average value of the genuine product delivery probabilities of all of the stations that belong to the ward of "Koto Ward" is calculated. For example, according to the example illustrated in FIG. 6, two stations, such as a station of "Koto Ward A" and the station of "Koto Ward B" belong to the ward of "Koto Ward". In this case, by obtaining an average of the genuine product delivery probability of "80%" of the station of "Koto Ward A" and the genuine product delivery probability of "70%" of the station of "Koto Ward B", an average value of the genuine product delivery probabilities of all of the stations that belong to the ward of "Koto Ward" is calculated as "75%". As a result, the average value of the genuine product delivery probabilities of all of the stations that belong to the ward of "Koto Ward" is updated from "76%" to "75%" as illustrated in FIG. 7.

Meanwhile, FIG. 7 illustrates the example in which the average value of the genuine product delivery probabilities of the stations is calculated, but embodiments are not limited to this example. For example, as for the genuine product delivery probabilities of the stations, it may be possible to calculate the average value of the genuine product delivery probabilities of the stations by day of week, by weekdays and holidays, or by the period of time. Furthermore, FIG. 7 illustrates the example in which the average value of the genuine product delivery probabilities of all of the stations that belong to the ward is calculated, but it may be possible to calculate an average value of the non-genuine product delivery probabilities, or it may be possible to calculate an arbitrary statistical value, such as a medial value, a mode value, a maximum value, or a minimum value.

Moreover, FIG. 6 and FIG. 7 illustrate the station evaluation table 13C1 and the ward evaluation table 13C2, but the tables are mere examples, and a data structure is not limited to a relational database. For example, it may be possible to adopt data that is written in a tag format that is written by a markup language, such as Extensible Markup Language (XML), or data that is written by comma or line break, such as Comma-Separated Values (CSV).

Referring back to explanation of FIG. 5, the output unit 15E is a processing unit that performs various kinds of output control with respect to the on-vehicle device 50. As only one example, the output unit 15E controls display on the display input unit 53 that is included in the on-vehicle device 50. Here, as one example of output that is controlled by the output unit 15E, display output will be described; however, it is of course possible to control other kind of output, such as print output or voice output.

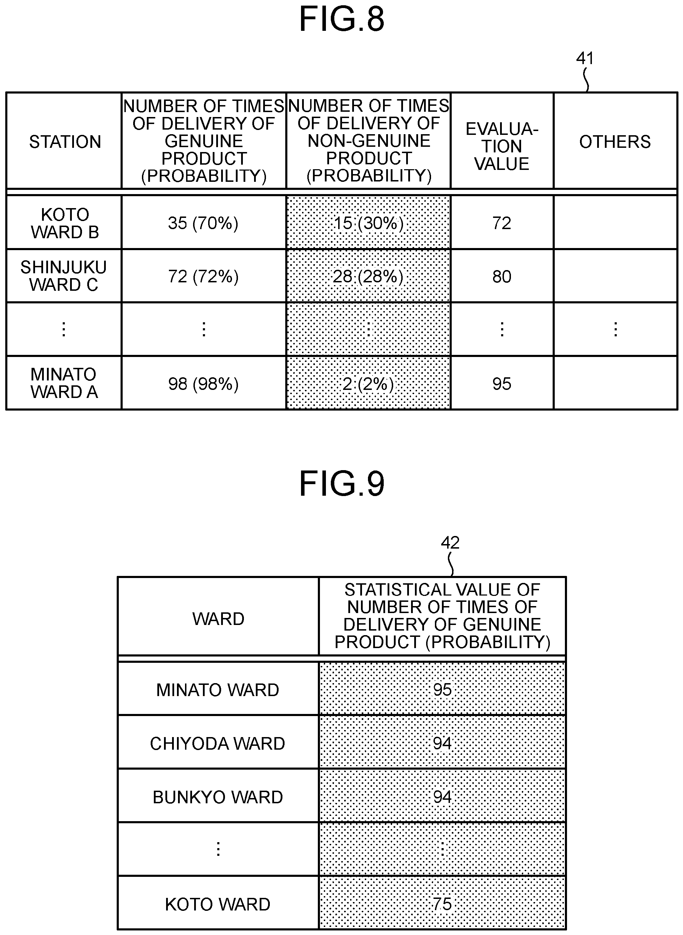

As one aspect, the output unit 15E is able to output a list in which evaluation of stations are listed for each of stations. FIG. 8 is a diagram illustrating a display example of the on-vehicle device 50. As only one example, FIG. 8 illustrates a list 41 in which the station evaluation table 13C1 illustrated in FIG. 6 is sorted in descending order of non-genuine product delivery probability. As illustrated in FIG. 8, in the list 41, the stations 30 are displayed such that the stations 30 are aligned in descending order from the station 30 with the highest non-genuine product delivery probability. With the display of the list 41 as described above, it is possible to easily recognize a station that highly frequently delivers a non-genuine battery to a user, so that it is possible to easily find a defective store that commits fraud.

Meanwhile, although not illustrated in the drawings, it may be possible to register, in a black list, a user whose non-genuine product delivery probability is in a top specific number of the non-genuine product delivery probabilities or a user whose non-genuine product delivery probability exceeds an upper limit value. Furthermore, FIG. 8 illustrates an example in which the station evaluation table 13C1 illustrated in FIG. 6 is sorted in descending order of non-genuine product delivery probability, but embodiments are not limited to this example. For example, the station evaluation table 13C1 illustrated in FIG. 6 may be sorted in descending order of genuine product delivery probability. In this case, it is possible to easily recognize an excellent store that highly frequently delivers a genuine battery to a user.

As another aspect, the output unit 15E is able to output a statistical value of evaluation of all of stations that belong to a certain ward, for each of wards. FIG. 9 is a diagram illustrating a display example of the on-vehicle device 50. As only one example, FIG. 9 illustrates a list 42 in which the average value of the genuine product delivery probabilities of each of the wards included in the ward evaluation table 13C2 that is illustrated in FIG. 7 is sorted in descending order. As illustrated in FIG. 9, in the list 42, users are displayed such that the users are aligned in descending order from a user with the highest genuine product delivery probability. With the display of the list 42 as described above, it is possible to easily recognize a ward in which it is highly likely to deliver a genuine battery to a user, so that it is possible to recommend a ward that is suitable for opening of a new store or opening of an additional store.

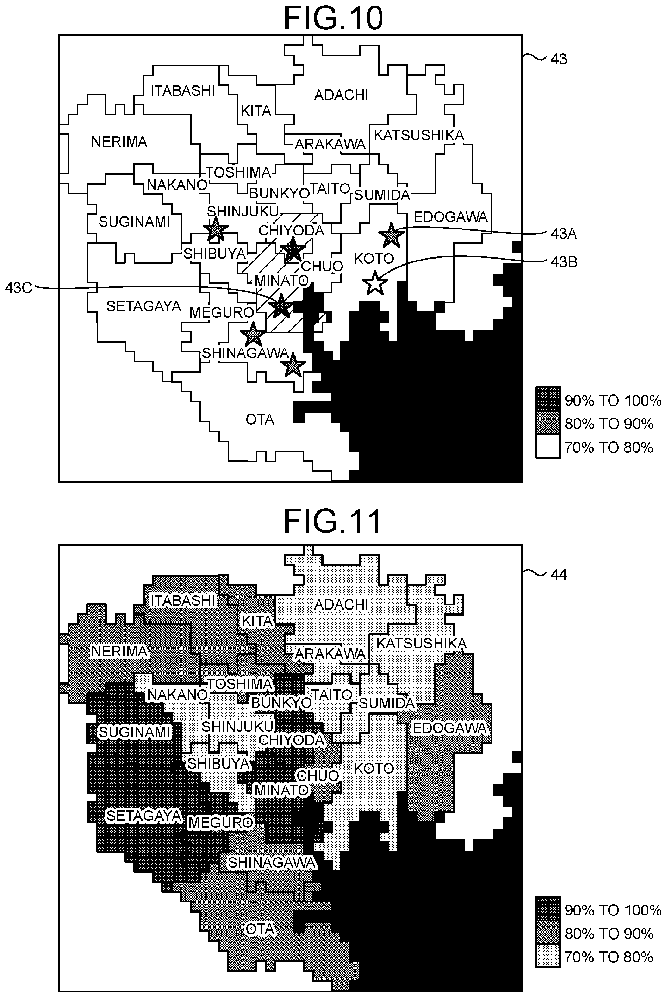

As still another aspect, the output unit 15E is able to output evaluation of stations in a manner of mapping on a map. FIG. 10 is a diagram illustrating a display example of the on-vehicle device 50. As illustrated in FIG. 10, the display input unit 53 of the on-vehicle device 50 displays map data 43 of a region that includes a plurality of wards, such as 23 wards in Tokyo. In the map data 43, a symbol, such as a star-shaped icon, that represents the station 30 is plotted at coordinates that correspond to a location of the station 30 for each of the stations 30.

For example, with respect to the examples of the stations that are included in the station evaluation table 13C1 illustrated in FIG. 6, a symbol 43A that represents the station of "Koto Ward A" is plotted at coordinates corresponding to a location of the station of "Koto Ward A". Further, a symbol 43B that represents the station of "Koto Ward B" is plotted at coordinates corresponding to a location of the station of "Koto Ward B". Furthermore, a symbol 43C that represents a station of "Minato Ward A" is plotted at coordinates corresponding to a location of the station of "Minato Ward A".

A display mode, such as the way of painting, of the symbols 43A to 43C as described above may be changed depending on the genuine product delivery probability of each of the stations, such as the station of "Koto Ward A", the station of "Koto Ward B", and the station of "Minato Ward A".

Specifically, the way of painting of the symbols 43A to 43C is distinguished in accordance with explanatory notes illustrated in FIG. 10. For example, as indicated by the station evaluation table 13C1 illustrated in FIG. 6, the genuine product delivery probability of the station of "Koto Ward A" is "80%", and therefore, the symbol 43A is displayed by a dotted pattern. Further, the genuine product delivery probability of the station of "Koto Ward B" is "70%", and therefore, the symbol 43B is white-painted. Furthermore, the genuine product delivery probability of the station of "Minato Ward A" is "98%", and therefore, the symbol 43C is black-painted.

According to the map data 43 as described above, it is possible to provide information that contributes to determination on whether or not the station 30 is good. As one aspect, in the example of the station of "Minato Ward A", the genuine product delivery probability is "98%", which is higher than the other stations, and therefore, it is possible to determine that the station 30 is an excellent store.

In addition, in the map data 43, display modes of a specific number of stations, such as the top-two stations, from the station with the highest genuine product delivery probability among all of the stations in the ward included in the map data 43 are distinguished from display modes of the other wards. For example, in the example illustrated in FIG. 10, a ward of "Chiyoda Ward" and a ward of "Minato Ward", which correspond to the highest and the second highest genuine product delivery probabilities among all of the stations, are displayed by diagonal hatchings. Therefore, as one aspect, from the viewpoint of a business operator who will open a store in the ward of "Chiyoda Ward" and the ward of "Minato Ward", it is possible to appeal operational achievements to a user. As another aspect, from the viewpoint of a business operator who considers opening of a new station or opening of an additional station, it is possible to provide a recommendation to improve a motivation to opening of a new store or opening of an additional store in the ward of "Chiyoda Ward" and the ward of "Minato Ward" for which a brand image of an excellent store is established. Furthermore, it is possible to provide, in a cooperative manner, information related to a subsidy project of the country or local government with regard to opening of a new station or opening of an additional station.

As another aspect, the output unit 15E is able to output a statistical value of evaluation of all of the stations 30 that belong to a ward, for each of wards that are included in the map. FIG. 11 is a diagram illustrating a display example of the on-vehicle device 50. As illustrated in FIG. 11, in the display input unit 53 of the on-vehicle device 50, map data 44 of a region that includes a plurality of wards, such as 23 wards in Tokyo, is displayed. A display mode, such as the way of painting, of each of the wards that are included in the map data 44 is changed depending on the genuine product delivery probability of all of the stations 30 that belong to the ward. Specifically, the way of painting of each of the wards is distinguished in accordance with explanatory notes as illustrated in FIG. 10. For example, display of the painting of each of the wards is darkened in ascending order of the genuine product delivery probability, that is, a ward in which the genuine product delivery probability is 70% to 80%, a ward in which the genuine product delivery probability is 80% to 90%, and a ward in which the genuine product delivery probability is 90% to 100% in this order. By the display of the map data 44 as described above, it is possible to overview and recognize a ward with a high genuine product delivery probability and a ward with a low genuine product delivery probability.

Meanwhile, the examples have been described above in which display on the on-vehicle device 50 as illustrated in FIG. 8 to FIG. 11 is automatically performed in response to installation of a battery in the vehicle 5, but a condition to start execution of the process is not limited to the examples as described above. For example, it may be possible to perform the process when the output unit 15E receives an evaluation output request from the on-vehicle device 50. In addition, the display illustrated in FIG. 8 to FIG. 11 may be generated, as a report, for each arbitrary period, such as a week, a month, a quarter, a half of the year, or a year. Further, the examples have been described above in which the on-vehicle device 50 performs display as illustrated in FIG. 8 to FIG. 11, but the display as illustrated in FIG. 8 to FIG. 11 may be performed by adopting a different computer from the on-vehicle device 50 as a client terminal.

### Flow of process

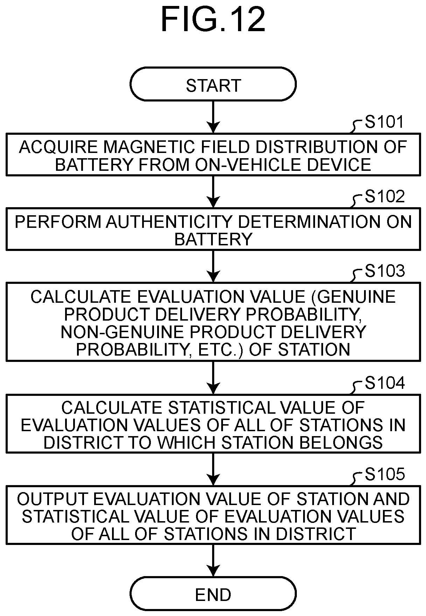

FIG. 12 is a flowchart illustrating the flow of a station evaluation process. As illustrated in FIG. 12, the acquisition unit 15B acquires a magnetic field distribution of a battery that is measured by the measurement unit 51 of the on-vehicle device 50 when the battery is mounted on the vehicle 5 (Step S101).

Subsequently, the determination unit 15C performs authenticity determination on whether or not the battery that is mounted on the vehicle 5 is a genuine product based on a result of comparison between the magnetic field distribution of the battery that is acquired at Step S101 and a reference magnetic field distribution that is stored in the reference information 13B (Step S102).

Further, the evaluation unit 15D calculates an evaluation value, such as the genuine product delivery probability, of the station 30 that charges the battery before installation in the vehicle 5, based on a result of the authenticity determination at Step S102 (Step S103).

Furthermore, the evaluation unit 15D calculates a statistical value of the evaluation values of all of the stations in a ward to which the station 30 belongs, based on the evaluation value of the station that is calculated at Step S103 (Step S104).

Thereafter, the output unit 15E outputs the evaluation value of the station that is calculated at Step S103 and the statistical value of the evaluation values of all of the stations in the ward that is calculated at Step S104 to the display input unit 53 of the on-vehicle device 50 (Step S105), and the process is terminated.

### One aspect of effects

As described above, the server device 10 according to the present embodiment acquires the magnetic field distribution of the battery 3 that is installed in the vehicle 5. Further, the server device 10 performs authenticity determination on whether or not the battery 3 is a genuine product based on the magnetic field distribution of the battery 3. Thereafter, the server device 10 evaluates the station 30 that has delivered the battery 3, based on a result of the authenticity determination on the battery 3. Based on the above, the server device 10 outputs station evaluation. Therefore, according to the server device 10 of the present embodiment, it is possible to provide information that contributes to determination on whether or not the station is good.

### Numerical values or the like

Specific examples of matters described in the embodiments as described above, such as the number of the magnetic sensors that are included in the measurement unit 51 of the on-vehicle device 50, are mere examples, and may be changed. Furthermore, in the flowchart described in the embodiments, order of processes may be changed as long as no contradiction is derived.

### System

The processing procedures, control procedures, specific names, and information including various kinds of data and parameters illustrated in the above-described document and drawings may be arbitrarily changed unless otherwise specified. For example, at least one functional unit among the providing unit 15A, the acquisition unit 15B, the determination unit 15C, the evaluation unit 15D, and the output unit 15E may be configured with a different device.

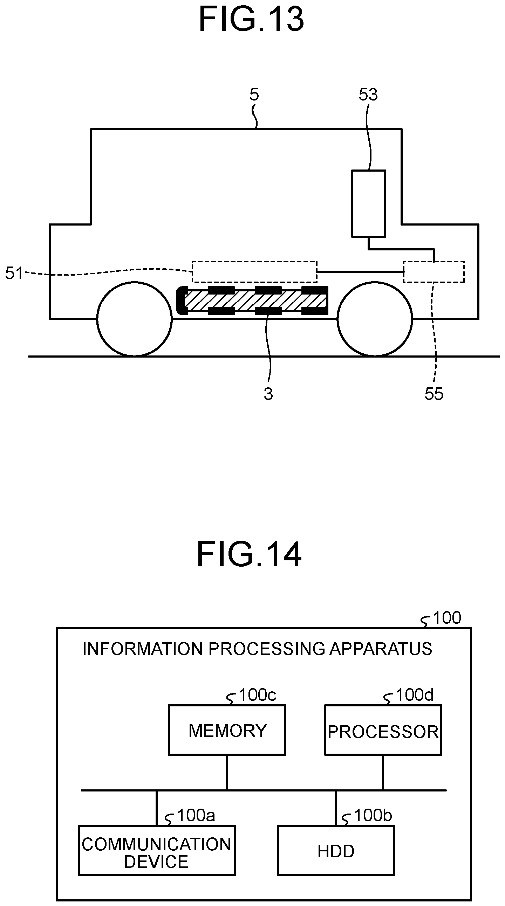

For example, in the embodiments as described above, the example has been described in which the server device 10 includes the providing unit 15A, the acquisition unit 15B, the determination unit 15C, the evaluation unit 15D, and the output unit 15E, but the on-vehicle device 50 may include the providing unit 15A, the acquisition unit 15B, the determination unit 15C, the evaluation unit 15D, and the output unit 15E. FIG. 13 is a diagram illustrating an application example of the on-vehicle device 50. As illustrated in FIG. 13, the on-vehicle device 50 includes the measurement unit 51, the display input unit 53, and a control unit 55. Of the units as described above, the control unit 55 may be implemented by a hardware processor. For example, the control unit 55 may be implemented by an Electronic Control Unit (ECU) or the like. Even when the control unit 55 as described above includes the providing unit 15A, the acquisition unit 15B, the determination unit 15C, the evaluation unit 15D, and the output unit 15E, it is possible to perform the same process as those performed by the server device 10 that is explained in the embodiments as described above, such as the process as illustrated in FIG. 12.

The components of the apparatuses illustrated in the drawings are functionally conceptual and do not necessarily have to be physically configured in the manner illustrated in the drawings. In other words, specific forms of distribution and integration of the apparatuses are not limited to those illustrated in the drawings. That is, all or part of the apparatuses may be functionally or physically distributed or integrated in arbitrary units depending on various loads or use conditions. Meanwhile, each of the configurations may be a physical configuration.

Moreover, all or an arbitrary part of processing functions that are implemented by the apparatuses may be realized by a CPU and a program analyzed and executed by the CPU, or may be realized by hardware using wired logic.

### Hardware

A hardware configuration example of the computer described in the embodiments will be described below. FIG. 14 is a diagram illustrating a hardware configuration example. As illustrated in FIG. 14, an information processing apparatus 100 includes a communication device 100a, a Hard Disk Drive (HDD) 100b, a memory 100c, and a processor 100d. Meanwhile, the units illustrated in FIG. 14 are connected to one another via a bus or the like.

The communication device 100a is a network interface card or the like, and performs communication with a different server. The HDD 100b stores therein a program and a database (DB) for operating the functions as illustrated in FIG. 5.

The processor 100d reads a program that executes the same processes as those of each of the processing units illustrated in FIG. 5 from the HDD 100b or the like, loads the program onto the memory 100c, and operates the processes for implementing each of the functions as described above with reference to FIG. 5 or the like. For example, the processes execute the same functions as those of the processing units included in the server device 10. Specifically, the processor 100d reads, from the HDD 100b or the like, a program that has the same functions as those of the providing unit 15A, the acquisition unit 15B, the determination unit 15C, the evaluation unit 15D, the output unit 15E, and the like. Further, the processor 100d executes a process that implements the same processes as those of the providing unit 15A, the acquisition unit 15B, the determination unit 15C, the evaluation unit 15D, the output unit 15E, and the like.

In this manner, by reading and executing the program, the information processing apparatus 100 operates as an information processing apparatus that implements an evaluation method. Further, the information processing apparatus 100 may be able to implement the same functions as those of the embodiments as described above by causing a medium reading apparatus to read the above-described program from a recording medium and executing the read program. Meanwhile, the program described in this embodiment need not always be executed by the information processing apparatus 100. For example, the present invention may be applied in the same manner to a case in which a different computer or a server executes the program and a case in which the different computer and the server execute the program in a cooperative manner.

The program as described above may be distributed via a network, such as the Internet. Further, the program as described above may be recorded in an arbitrary recording medium, and may be executed by being read from the recording medium by the computer. For example, the recording medium may be implemented by a hard disk, a flexible disk (FD), a compact disk read only memory (CD-ROM), a Magneto-Optical disk (MO), a Digital Versatile Disc (DVD), or the like.

## Claims

1. An information processing apparatus (10) comprising:
an acquisition unit (15B) configured to acquire a magnetic field distribution of a battery that is installed in a vehicle;
a determination unit (15C) configured to perform authenticity determination on whether the battery is a genuine product based on the magnetic field distribution of the battery;
an evaluation unit (15D) configured to evaluate a charging device serving as a delivery source of the battery that is installed in the vehicle among charging devices that charge a battery that is brought by a user and deliver a charged battery to the user in place of the battery, based on a result of the authenticity determination; and
an output unit (15E) configured to output evaluation of the charging device, the evaluation being made by the evaluation unit (15D).

2. The information processing apparatus (10) according to claim 1, wherein the determination unit (15C) determines whether the battery is a genuine product based on a comparison between the magnetic field distribution of the battery and a magnetic field distribution of a genuine battery.

3. The information processing apparatus (10) according to claim 1, wherein the evaluation unit (15D) evaluates a frequency at which the battery is determined as the genuine product.

4. The information processing apparatus (10) according to claim 1, wherein the evaluation unit (15D) evaluates a frequency at which the battery is determined as a non-genuine product that is not the genuine product.

5. The information processing apparatus (10) according to any one of claims 1 to 4, wherein the evaluation unit (15D) calculates a statistical value of the evaluation of the charging device by one of classification of a region to which the charging device belongs, day of week, weekdays and holidays, and a period of time.

6. The information processing apparatus (10) according to any one of claims 1 to 4, wherein the output unit (15E) outputs the evaluation of the charging device by mapping the evaluation on a map.

7. The information processing apparatus (10) according to claim 6, wherein the output unit (15E) outputs a statistical value of evaluation of a charging device that belongs to a ward for each of wards that are included in the map.

8. The information processing apparatus (10) according to any one of claims 1 to 4, wherein the output unit (15E) outputs a list in which evaluation of charging devices is listed for each of the charging devices.

9. An evaluation method carried out by a computer (100) comprising:
acquiring (S101) a magnetic field distribution of a battery that is installed in a vehicle;
performing (S 102) authenticity determination on whether the battery is a genuine product based on the magnetic field distribution of the battery;
evaluating (S103, S104) a charging device serving as a delivery source of the battery that is installed in the vehicle among charging devices that charge a battery that is brought by a user and deliver a charged battery to the user in place of the battery, based on a result of the authenticity determination; and
outputting (S105) evaluation of the charging device.

10. An evaluation program that causes a computer to execute a process comprising:
acquiring (S101) a magnetic field distribution of a battery that is installed in a vehicle;
performing (S 102) authenticity determination on whether the battery is a genuine product based on the magnetic field distribution of the battery;
evaluating (S103, S104) a charging device serving as a delivery source of the battery that is installed in the vehicle among charging devices that charge a battery that is brought by a user and deliver a charged battery to the user in place of the battery, based on a result of the authenticity determination; and
outputting (S105) evaluation of the charging device.
